(19) Europäisches Patentamt
European Patent Office
Office européen des brevets

(11) **EP 4 237 907 B1**

(12) **FASCICULE DE BREVET EUROPEEN**

(45) Date de publication et mention
de la délivrance du brevet:
**10.12.2025 Bulletin 2025/50**

(21) Numéro de dépôt: **21794853.8**

(22) Date de dépôt: **20.10.2021**

(51) Classification Internationale des Brevets (IPC):
**H01L 21/00** (2006.01)

(52) Classification Coopérative des Brevets (CPC):
**G02F 1/01791; G02F 1/01783; H10H 20/812;**
**H10H 20/8142;** H10H 20/819; H10H 29/10

(86) Numéro de dépôt international:
**PCT/EP2021/079092**

(87) Numéro de publication internationale:
**WO 2022/090028 (05.05.2022 Gazette 2022/18)**

(54) **DISPOSITIF DE GÉNÉRATION DE PHOTONS UNIQUES ET DE PAIRES DE PHOTONS INTRIQUÉS**

VORRICHTUNG ZUR ERZEUGUNG EINZELNER PHOTONEN UND VERSCHRÄNKTER PHOTONENPAARE

DEVICE FOR GENERATING SINGLE PHOTONS AND ENTANGLED PHOTON PAIRS

(84) Etats contractants désignés:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priorité: **28.10.2020 FR 2011044**

(43) Date de publication de la demande:
**06.09.2023 Bulletin 2023/36**

(73) Titulaires:
• **Centre National de la Recherche Scientifique**
**75016 Paris (FR)**
• **Université Paris Cité**
**75006 Paris (FR)**
• **Université Paris-Saclay**
**91190 Saint-Aubin (FR)**

(72) Inventeurs:
• **SENELLART MARDON, Pascale**
**91400 ORSAY (FR)**
• **OLLIVIER, Hélène**
**29980 ILE-TUDY (FR)**
• **LANCO, Loïc**
**75013 PARIS (FR)**

(74) Mandataire: **IPAZ**
**Bâtiment Platon**
**Parc Les Algorithmes**
**91190 Saint-Aubin (FR)**

(56) Documents cités:
**US-A1- 2018 108 804**

• **N. SOMASCHI ET AL: "Near-optimal single-**
**photon sources in the solid state", NATURE**
**PHOTONICS, vol. 10, no. 5, 7 March 2016**
**(2016-03-07), UK, pages 340 - 345, XP055497890,**
**ISSN: 1749-4885, DOI: 10.1038/nphoton.2016.23**
• **ANONYMOUS: "Deterministic and electrically**
**tunable bright single-photon source | Nature**
**Communications", 5 February 2014 (2014-02-05),**
**pages 1 - 21, XP055818260, Retrieved from the**
**Internet <URL:https://www.nature.com/articles/**
**ncomms4240> [retrieved on 20210625]**
• **MOHD ZEESHAN ET AL: "Proposed Scheme to**
**Generate Bright Entangled Photon Pairs by**
**Application of a Quadrupole Field to a Single**
**Quantum Dot", ARXIV.ORG, CORNELL**
**UNIVERSITY LIBRARY, 201 OLIN LIBRARY**
**CORNELL UNIVERSITY ITHACA, NY 14853, 7**
**September 2018 (2018-09-07), XP081435639,**
**DOI: 10.1103/PHYSREVLETT.122.227401**

- A. J. BENNETT ET AL: "Electric-field-induced coherent coupling of the exciton states in a single quantum dot", NATURE PHYSICS, vol. 6, no. 12, 3 October 2010 (2010-10-03), GB, pages 947 - 950, XP055225082, ISSN: 1745-2473, DOI: 10.1038/nphys1780
- MOREAU E ET AL: "Single-mode solid-state single photon source based on isolated quantum dots in pillar microcavities", APPLIED PHYSICS LETTERS, A I P PUBLISHING LLC, US, vol. 79, no. 18, 29 October 2001 (2001-10-29), pages 2865 - 2867, XP012029243, ISSN: 0003-6951, DOI: 10.1063/1.1415346
- H\'EL\'ENE OLLIVIER ET AL: "Reproducibility of high-performance quantum dot single-photon sources", ARXIV.ORG, CORNELL UNIVERSITY LIBRARY, 201 OLIN LIBRARY CORNELL UNIVERSITY ITHACA, NY 14853, 20 October 2019 (2019-10-20), XP081517975
- ADRIEN DOUSSE ET AL: "Ultrabright source of entangled photon pairs", NATURE, vol. 466, no. 7303, 1 July 2010 (2010-07-01), London, pages 217 - 220, XP055571957, ISSN: 0028-0836, DOI: 10.1038/nature09148

## Description

## Art antérieur

La présente invention concerne généralement les sources de photons et en particulier un dispositif de génération de photons uniques et de paires de photons intriqués, et des procédés mettant en œuvre le dispositif.

Le déploiement d'un réseau de communication quantique requiert la mise en place d'une source de photons uniques capable de générer un train d'impulsions optiques où chaque impulsion comprend un, et un seul photon. De telles sources sont capables de fournir à deux interlocuteurs distants une clé secrète leur permettant de chiffrer des communications ultérieures. Les imperfections du canal de propagation, fibres optiques ou espace libre, limitent la portée d'une telle application à quelques centaines de kilomètres. La portée des réseaux de communication quantique peut être étendue au moyen de répéteurs quantiques qui se reposent sur l'intrication d'une paire de photons. La génération des impulsions à un seul photon ou des paires de photons intriqués peuvent s'effectuer au moyen d'émetteurs de taille nanométrique de sorte que la transition entre leurs états électroniques corresponde au rayonnement d'un dipôle quantique unique.

Par ailleurs, l'élaboration d'un ordinateur quantique se repose sur des systèmes exploitables en tant que bits quantiques. Un bit quantique est une superposition cohérente de deux états de base communément notés $|0>$ et $|1>$ de sorte qu'il peut prendre une infinité de valeurs possibles contrairement aux bits binaires manipulés par les ordinateurs classiques valant 0 ou 1. Les bits quantiques peuvent être à l'état solide ou de nature photonique. Alors que le premier type offre une flexibilité en matière de stockage et de traitement, les bits quantiques photoniques permettent un transport sur des longues portées de l'information quantique. Afin de permettre le traitement et le transport de l'information quantique, il est d'usage d'utiliser conjointement des bits quantiques à l'état solide et des bits quantiques photoniques en association avec une interface entre les deux éléments.

L'utilisation des boîtes quantiques dans des applications incluant le déploiement d'un réseau de communication quantique et l'élaboration d'un ordinateur quantique a connu un essor majeur ces dernières années. L'intérêt porté à des telles structures nanométriques s'explique par leurs similitudes avec l'atome en termes de confinement de porteurs de charge et de quantification de leurs niveaux d'énergie. De telles caractéristiques permettent à une boîte quantique de générer un photon unique à travers un processus d'émission spontanée en réponse à une excitation lumineuse adaptée permettant de faire migrer un électron de la bande de valence à la bande de conduction. Le même mécanisme peut être adapté pour placer deux électrons dans un même niveau d'énergie de la bande de conduction et de générer une paire de photons intriqués. Les boîtes quantiques permettent également une interaction fiable de la lumière avec les caractéristiques des porteurs de charge confinés.

Des boîtes quantiques isolées utilisées en tant que source de photons uniques ou de paires de photons intriqués sont généralement limitées en matière de brillance et de débit. Alors que la brillance quantifie la probabilité d'avoir un photon unique ou une paire de photons intriqués par impulsion optique, le débit mesure le nombre de photons émis par seconde et est égal au produit de la brillance telle que définie ci-dessus et la cadence de l'horloge de l'émission régissant les impulsions optiques qui excitent la boîte quantique. Afin d'améliorer les performances des boîtes quantiques en matière de brillance et de débit, il est connu d'insérer la boîte quantique dans une cavité optique résonante. Une telle configuration exploite l'effet Purcell, aussi connu sous le terme de régime de couplage faible lumière-matière, pour augmenter le taux d'émission spontanée de la boîte quantique dans le mode de cavité et permet de collecter plus efficacement les photons émis par la boîte quantique. L'encapsulation de la boîte quantique dans une cavité optique permet aussi de réduire la sensibilité de la boîte quantique aux perturbations environnementales (mécaniques, électriques ou autre) et permet de générer des photons uniques indiscernables, c'est-à-dire identiques en termes d'état quantique (même fréquence, même état de polarisation, même distribution spatiale et temporelle).

Les boîtes quantiques sont généralement de nature semi-conductrice obtenues par un procédé d'épitaxie par jet moléculaire consistant à faire croître des couches de semi-conducteurs différents en matière d'énergie de gap et de paramètres de maille. De telles différences créent des boîtes quantiques de dimensions nanométriques capables de confiner des porteurs de charge dans les trois dimensions de l'espace.

Un électron de la bande de valence de la boîte quantique peut transiter à la bande de conduction pour former, en association avec le trou laissé dans la bande de valence, une paire électron-trou, appelé aussi exciton. La formation d'un exciton peut se faire en absorbant un photon d'énergie supérieure ou égale à la bande interdite du matériau formant la boîte quantique. L'état exciton correspondant à la formation d'un exciton est un état instable et le rétablissement de l'état neutre, appelé aussi état fondamental, se fait par recombinaison de l'électron avec le trou avec émission d'un photon selon un processus d'émission spontanée caractérisé par un temps de vie radiatif de l'ordre de la nanoseconde et d'une longueur d'onde (ou fréquence) d'émission correspondant à la bande interdite du matériau formant la boîte quantique.

Une boîte quantique peut confiner un biexciton formé de deux excitons couplés par l'interaction coulombienne en partageant un même état fondamental. Le niveau d'énergie de l'état de biexciton est supérieur à celui occupé par celui d'un seul exciton. La formation d'un biexciton peut s'effectuer en absorbant successivement deux photons. La relaxation d'un biexciton s'effectue également selon un processus d'émission spontanée qui donne naissance à deux photons émis successivement. Les deux photons sont émis à des longueurs d'onde différentes car l'interaction coulombienne est différente suivant qu'une paire électron-trou ou deux paires électron-trou sont excitées dans la boîte quantique. Ainsi le photon émis lors de la transition du système de l'état biexciton vers l'état exciton est d'une longueur d'onde différente de celui émis lors de la transition du système de l'état exciton vers l'état neutre.

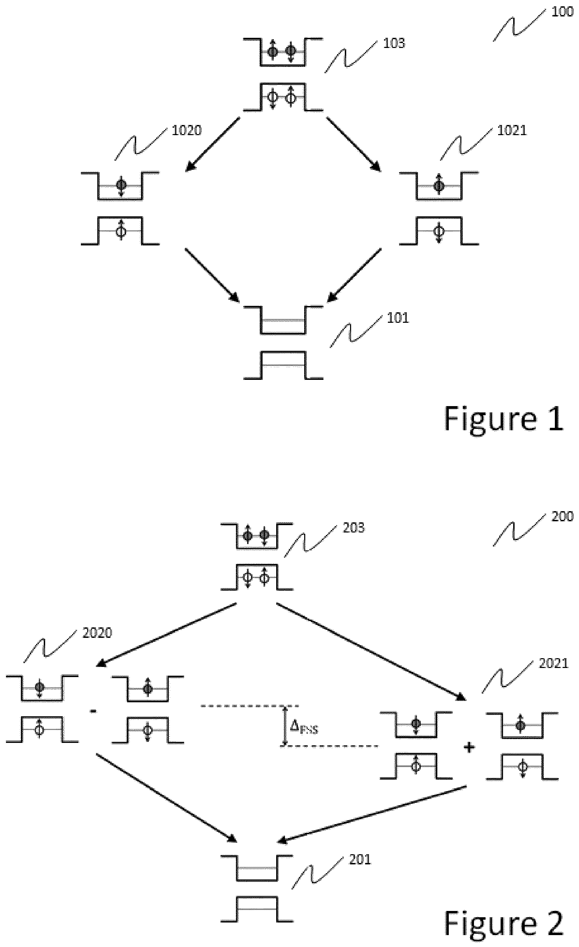

L'état de polarisation du photon absorbé pour former l'exciton et celui du photon émis lors de la recombinaison électron-trou obéissent à des règles de sélection optiques régies par le principe d'exclusion de Pauli et la conservation du moment angulaire. De telles règles de sélection dépendent des états de spin de la paire électron-trou et énoncent que les états excitoniques brillants émettant un photon lors de leur recombinaison sont ceux correspondant à des états de spin de signes opposés. Dans le cas où la boîte quantique présente une symétrie cylindrique, le système présente deux états excitoniques brillants dégénérés en énergie. La figure 1 représente la relaxation d'un biexciton 103 formé dans une boîte quantique semi-conductrice à symétrie cylindrique (ou « isotrope ») 100 où seuls les états excitoniques brillants sont mis en œuvre. La relaxation d'un biexciton 103 confiné dans une boîte quantique isotrope 100 s'effectue dans un système à trois niveaux d'énergie en émettant successivement deux photons. Pour cela, deux chemins sont possibles :

- relaxation du biexciton 103 vers l'exciton 1020 avec émission d'un photon de polarisation circulaire droite, puis relaxation de l'exciton 1020 vers l'état fondamental 101 avec émission d'un photon de polarisation circulaire gauche ; ou

- relaxation du biexciton 103 vers l'exciton 1021 avec émission d'un photon de polarisation circulaire gauche, puis relaxation de l'exciton 1021 vers l'état fondamental 101 avec émission d'un photon de polarisation circulaire droite.

Etant donné que les deux chemins sont indiscernables, car les excitons 1020 et 1021 sont dégénérés, cela conduit à l'émission d'une paire de photons intriqués en polarisation.

Il est à noter que la génération de photons uniques peut s'effectuer en exploitant la recombinaison des excitons 1020 ou 1021 vers l'état fondamental 101 et qu'il est inutile, dans ce cas, de passer par un état biexciton 103. La création d'un biexciton 103 est requise pour la génération de paires de photons intriqués.

Cependant, en pratique, les boîtes quantiques semi-conductrices sont anisotropes impliquant une levée de dégénérescence du niveau exciton, et donc une perte de l'intrication des photons émis. Une telle levée de dégénérescence est principalement provoquée par des effets d'anisotropie de forme de la boîte quantique, des effets piézoélectriques, des contraintes mécaniques, etc. Dans une boîte quantique anisotrope les états excitoniques brillants sont séparés d'une quantité d'énergie appelée « dédoublement de structure fine » et sont des combinaisons linéaires des états de base tels que définis dans des boîtes quantiques symétriques. Les états excitoniques brillants dans une boîte quantique anisotrope présentent des émissions optiques polarisés linéairement suivant deux axes propres « x » et « y » correspondant aux directions cristallographiques (l'axe « z » étant l'axe de croissance). La figure 2 illustre la recombinaison d'un biexciton 203 dans une boîte quantique semi-conductrice anisotrope 200. La relaxation d'un biexciton 203 vers l'état fondamental 201 ne peut se faire que selon un état de polarisation linéaire selon l'un des axes propres de la boîte quantique, « x » ou « y », en laissant un exciton 2020 ou 2021 qui, à son tour, se relaxe selon le même état de polarisation que le biexciton 203. La levée de dégénérescence du niveau exciton conduit à la perte totale ou partielle de l'intrication entre les deux photons générés.

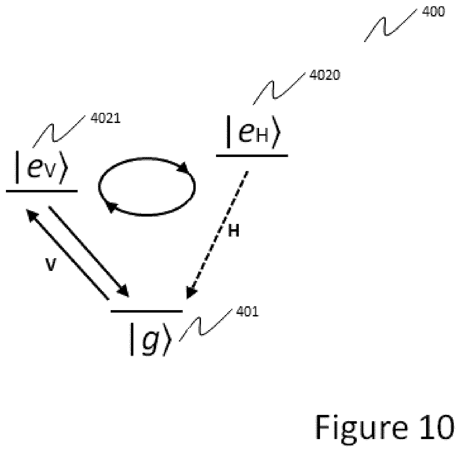

Il est connu d'utiliser des boîtes quantiques anisotropes pour générer des photons uniques de performances accrues en excitant de façon résonante une superposition des deux états excitoniques brillants et en exploitant l'évolution temporelle $\Delta\Phi$ de la phase entre les deux états excitoniques polarisés selon « x » et « y », dont la vitesse (appelée « vitesse de transfert », car elle régit le passage d'un état de polarisation linéaire des photons émis à un état orthogonal, comme cela sera expliqué plus en détail en référence à la figure 10) est proportionnelle à la valeur du dédoublement de structure fine selon la

relation suivante : $\Delta\Phi = \exp(i\frac{\Delta_{\mathrm{FSS}}}{\hbar}t)$, $\hbar$ étant la

constante de Planck réduite. L'excitation peut être faite avec des photons polarisés linéairement selon un axe non collinaire avec les axes propres de la boîte quantique, idéalement avec une orientation de 45 degrés. Afin de ne collecter que les photons générés par la boîte quantique, seuls les photons polarisés linéairement selon la direction perpendiculaire par rapport à celle des photons d'excitation sont détectés. Généralement, la valeur du dédoublement de structure fine détermine les performances de la source de photons uniques en termes de brillance et de pureté, la pureté quantifie la capacité de générer un seul photon pendant une même période d'excitation. La valeur du dédoublement de structure fine est difficilement contrôlable lors du processus de fabrication de la boîte quantique. Des valeurs élevées du déboulement de structure fine permettent d'augmenter la vitesse de transfert et, par conséquent, d'augmenter la brillance de la source de photons uniques. Cependant, la probabilité que la boîte quantique émette plus qu'un photon pendant une même période excitation lumineuse est non négligeable ce qui réduit les performances de la source de photons uniques en termes de pureté. Réciproquement, des faibles valeurs du dédoublement de structure fine réduisent la vitesse de transfert ce qui réduit la probabilité d'avoir un deuxième photon émis pendant une même période d'excitation. De telles faibles valeurs du dédoublement de structure fine améliorent la pureté de la source de photons uniques au détriment de la brillance qui se dégrade car la boîte quantique émet plus rapidement dans la polarisation parallèle à celle des photons d'excitation que dans la polarisation orthogonale. Il existe donc un besoin de contrôler la valeur du dédoublement de structure fine afin de générer des photons uniques selon une cadence élevée tout en réduisant la probabilité d'avoir plus qu'un photon émis pendant une même période d'excitation.

L'utilisation des boîtes quantiques anisotropes telles que fabriquées reste inadaptée à la génération de paires de photons intriqués à cause de la levée de dégénérescence de l'état exciton. Il existe donc un besoin de réduire de manière statique la valeur du dédoublement de structure fine, en particulier de l'annuler, afin de rétablir l'indiscernabilité des chemins d'émission radiative à partir du biexciton pour obtenir des paires de photons intriqués.

Il est connu de réduire et/ou de contrôler la valeur du dédoublement de structure fine dans une boîte quantique en appliquant un champ électrique vertical conjointement avec un ou des champs de contraintes, en l'occurrence de type mécanique, dans deux ou trois directions de l'environnement dans lequel la boîte quantique est insérée. Une telle solution a été démontrée dans [1] et [4]. L'application de tels champs de contraintes nécessite d'amincir les substrats sur lesquels la boîte quantique est réalisés afin de placer des matériaux piézoélectriques au plus près de la boîte quantique et de s'assurer que la tension mécanique appliquée soit bien transférée vers la boîte quantique mise en œuvre. L'amincissement nécessaire à la mise en œuvre d'une telle approche pose des défis technologiques pour la fabrication d'une cavité optique tridimensionnelle (3D) incorporant une boîte quantique. En outre, la proximité de la boîte quantique avec une surface la rend sensible aux perturbations environnementales ce qui provoque la perte d'indiscernabilité des photons uniques générés.

Il est aussi connu d'appliquer un champ électrique dans deux dimensions de l'espace dans lequel la boîte quantique est insérée afin de contrôler la valeur du dédoublement de structure fine. Une telle solution est mise en œuvre en [2] par l'insertion sur un plan très proche de celui de la boîte quantique de plusieurs (typiquement quatre) plots de contact électrique. La proximité de la boîte quantique de surfaces où sont définis de tels plots de contact électrique est connue pour augmenter le bruit de charge et de réduire les performances des photons émis en termes d'indiscernabilité.

Il existe donc un besoin d'une source de photons uniques ou de paires de photons intriqués à la base d'une boîte quantique semi-conductrice dans laquelle le dédoublement de structure fine peut être contrôlé de manière statique ou dynamique, ne présentant pas les inconvénients de l'art antérieur.

**Définition générale de l'invention**

A cet effet la présente invention fournit un dispositif de génération de photons comprenant une boîte quantique insérée dans une cavité optique de type micropilier présentant au moins un mode optique, la boîte quantique présentant au moins un état fondamental et deux états à une excitation élémentaire, la cavité optique présentant une face inférieure et une face supérieure, la face inférieure portant un contact électrique, caractérisé en ce qu'il comprend au moins trois plots de contact électrique isolés électriquement les uns des autres, agencés autour de la face supérieure de la cavité.

Dans un mode de réalisation, les plots de contact électrique peuvent être reliés à la face supérieure de la cavité par des bras semi-conducteurs orientés radialement par rapport à la cavité et présentant, dans une direction tangentielle et, à leur extrémité la plus proche, de la cavité, une largeur inférieure à celle de la cavité.

Dans un autre mode de réalisation, les plots de contact électrique peuvent être reliés à des bras semi-conducteurs orientés radialement vers la cavité et dont les extrémités peuvent être séparés de la face supérieure de la cavité par un intervalle vide, ou rempli de diélectrique, de largeur sub-micrométrique.

Avantageusement, la cavité optique de type micro-pilier peut former une diode de type P-I-N, la boîte quantique étant située dans une région intrinsèque de la diode.

En variante, les plots de contact électrique peuvent être portés par des piliers respectifs découplés optiquement et électriquement de la cavité.

Dans un mode de réalisation, le dispositif peut en outre comprendre au moins trois sources de tension réglables pour appliquer des différences de potentiel respectives et variables entre chacun des plots de contact électrique et le contact électrique porté par la face inférieure de la cavité optique.

Dans un autre mode de réalisation, la cavité optique de type micro-pilier peut présenter au moins une première et une deuxième paire de modes, chaque paire de modes étant dégénérée en polarisation, et dans lequel la boîte quantique peut présenter également un état à deux excitations élémentaires.

Avantageusement, le dispositif peut en outre comprendre une deuxième cavité optique couplée à la cavité optique dans laquelle est insérée la boîte quantique, la géométrie de la première et de la deuxième cavité et la force de leur couplage étant choisies de telle manière que l'ensemble constitué par les deux cavités couplées présente une première paire de modes dégénérés en polarisation et résonants avec les transitions entre l'état à deux excitations élémentaires et les deux états à une excitation élémentaire de la boîte quantique et une deuxième paire de modes dégénérés en polarisation et résonants avec les transitions entre les deux états à une excitation élémentaire et l'état fondamental de la boîte quantique, les modes de chacune des paires présentant des diagrammes de rayonnement se recouvrant à 70% ou plus.

En particulier, la deuxième cavité optique peut également être de type micro-pilier, les deux cavités étant agencées côte à côte.

Il est proposé un procédé de génération de paires de photons intriqués au moyen d'un dispositif de génération de photons, le procédé peut comprendre les étapes suivantes :

- appliquer une différence de potentiel entre chacun des plots de contact électrique et le contact électrique porté par la face inférieure de la cavité optique, les différences de potentiel étant choisies pour :

  ◦ minimiser un écart d'énergie entre les deux états à une excitation de la boîte quantique; et

  ◦ amener les transitions entre l'état à deux excitations élémentaires et les états à une excitation élémentaire en résonance avec la première paire de modes de la cavité, et les transitions entre les états à une excitation élémentaire et l'état fondamental en résonance avec la deuxième paire de modes de la cavité ; et

- peupler l'état à deux excitations élémentaires de la boîte quantique par un apport d'énergie.

Il est en outre proposé un procédé de génération de photons uniques au moyen d'un dispositif de génération de photons, le procédé peut comprendre les étapes suivantes :

- appliquer une différence de potentiel entre chacun des plots de contact électrique et le contact électrique porté par la face inférieure de la cavité optique; et
- éclairer la boîte quantique du dispositif par une impulsion lumineuse présentant un spectre et une direction de polarisation correspondant à un mode de la cavité optique ;

les différences de potentiel étant choisies pour modifier les énergies des deux états propres à une excitation élémentaires de telle sorte que :

  ◦ les états soient résonant avec des longueurs d'onde du spectre de l'impulsion lumineuse ; et

  ◦ la probabilité d'émission, par la boîte, d'un photon unique présentant une polarisation linéaire orthogonale à celle d'éclairage soit maximisée.

Dans un mode de réalisation, les différences de potentiel peuvent également être choisies pour orienter des axes propres de la boîte quantique selon des directions intermédiaires entre celles de deux axes propres de polarisation de la cavité optique.

Dans un autre mode de réalisation, les différences de potentiel peuvent être variables dans le temps et :

- pendant une première période, au cours d'au moins une partie de laquelle la boîte quantique est éclairée, prennent des premières valeurs choisies pour que les énergies des deux états propres à une excitation élémentaires présentent un écart non minimal, la première période présentant une durée choisie pour provoquer un évolution de phase comprise entre 45° et 135°, et de préférence entre 80° et 100°, entre les deux états ; et

- pendant une deuxième période, succédant immédiatement à la première période, prennent des valeurs choisies pour minimiser l'écart entre les énergies des deux états propres à une excitation élémentaire.

## Brève description des figures

D'autres caractéristiques et avantages de l'invention apparaîtront à l'aide de la description qui suit et des figures annexées dans lesquels :

[Fig. 1]
et

[Fig. 2] décrites plus haut, illustrent la relaxation d'un biexciton dans des boîtes quantiques isotropes et anisotropes, respectivement,

[Fig. 3A]
et

[Fig. 3B] représentent un dispositif de génération de photons uniques et de paires de photons intriqués selon un mode de réalisation de l'invention,

[Fig. 4] illustre la génération d'un champ électrique à trois composantes dans l'espace selon un mode de réalisation de l'invention,

[Fig.5],

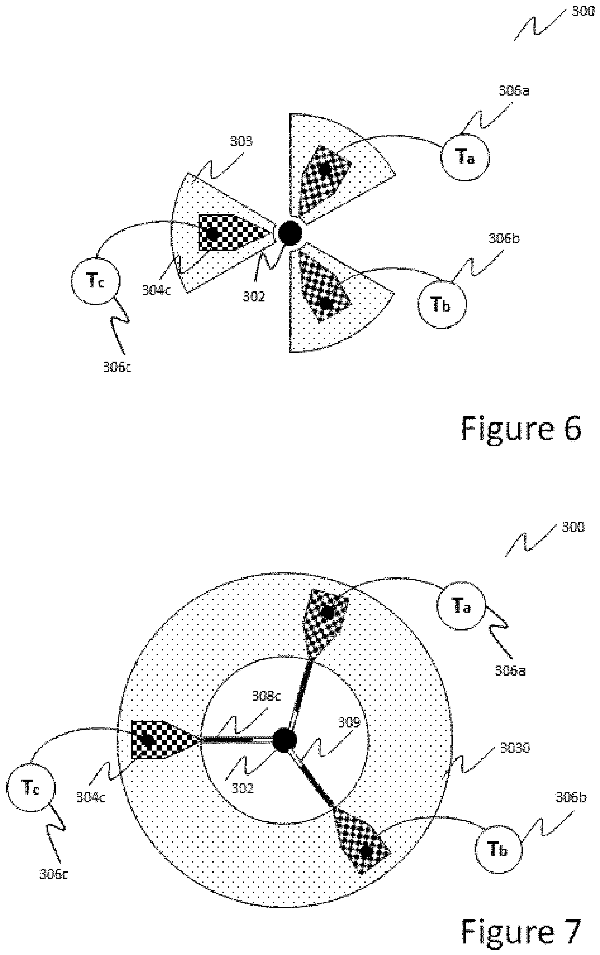

[Fig. 6] et

[Fig. 7] représentent une partie de la vue de haut d'un dispositif de génération de photons uniques et de paires de photons intriqués selon différents modes de réalisation de l'invention,

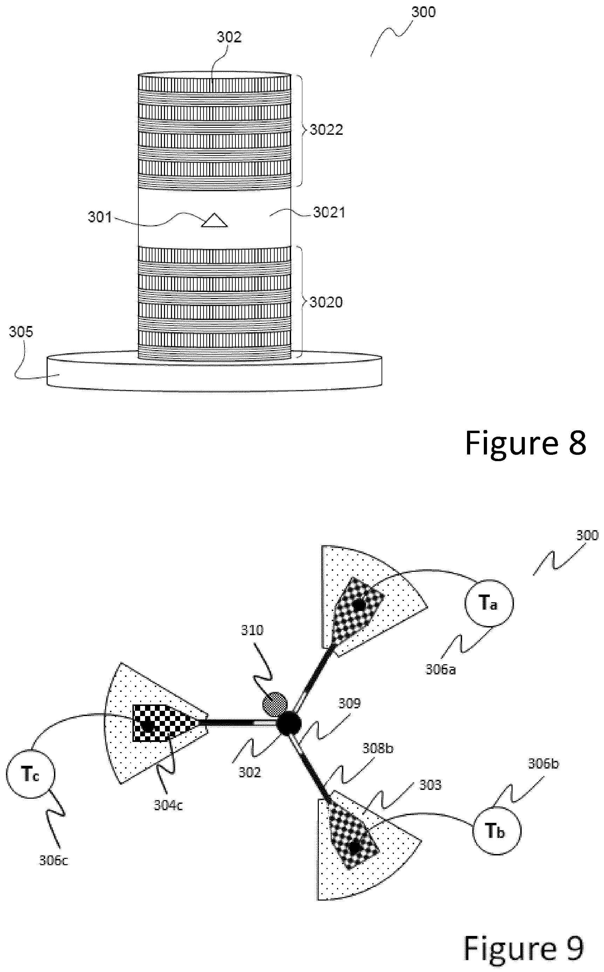

[Fig. 8] représente une cavité optique de type micro-pilier incorporant une boîte quantique selon un mode de réalisation de l'invention,

[Fig. 9] représente une partie de la vue de haut d'un dispositif de génération de photons uniques et de paires de photons intriqués mettant en œuvre deux cavités optiques couplées optiquement selon un autre mode de réalisation de l'invention,

[Fig. 10] représente l'évolution au cours du temps des états excités d'une boîte quantique incorporée dans une cavité optique de type micro-pilier, la boîte quantique présentant une anisotropie d'échange non nulle et la cavité optique présentant une biréfringence,

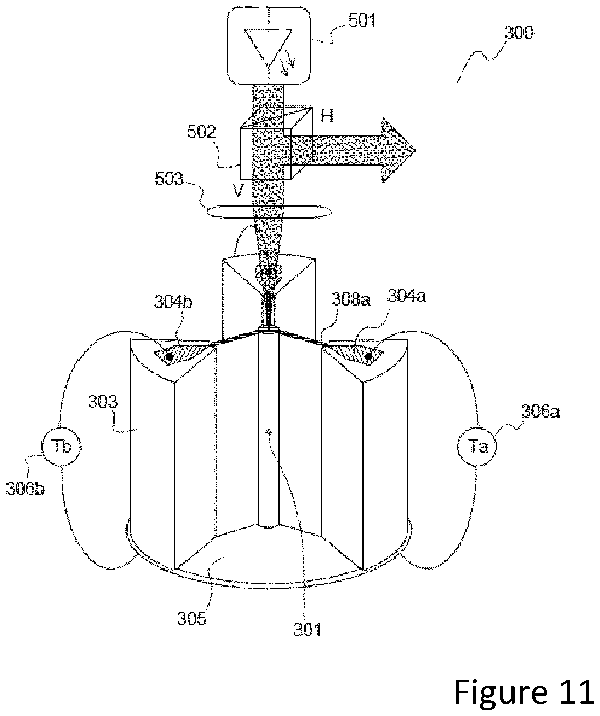

[Fig. 11] représente l'utilisation d'un dispositif de génération de photons uniques selon un mode de réalisation de l'invention,

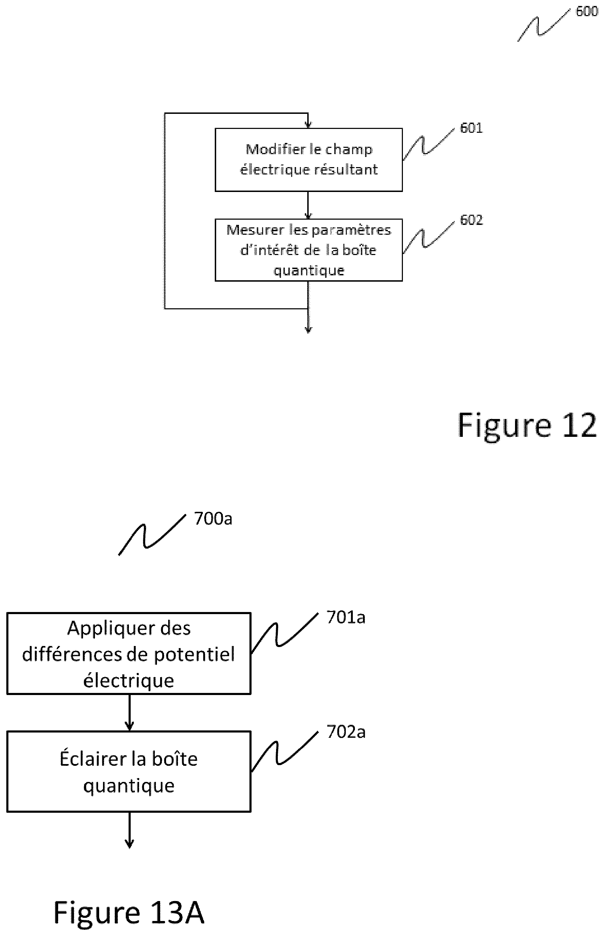

[Fig. 12] représente un procédé d'étalonnage d'une boîte quantique anisotrope,

[Fig. 13A] et

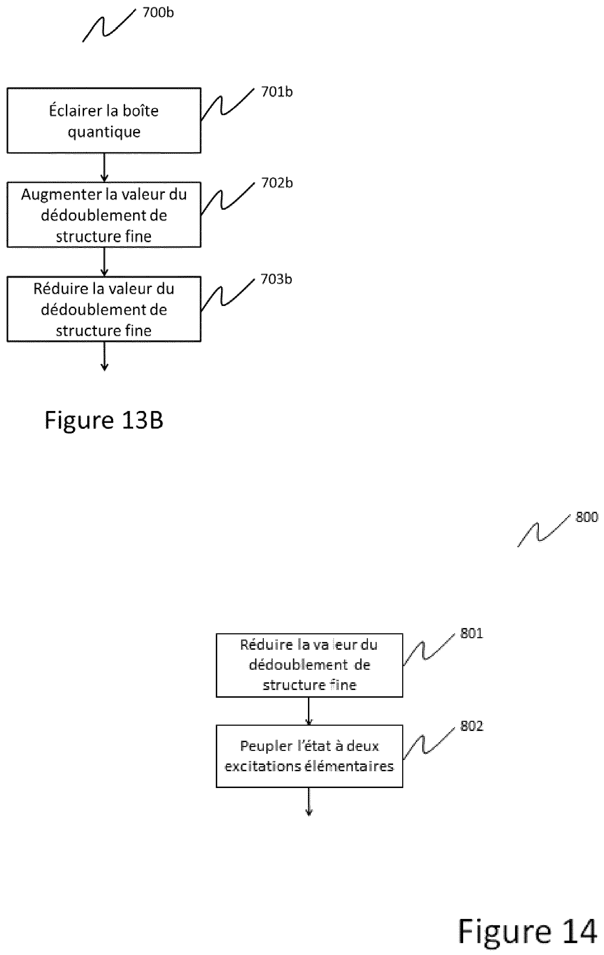

[Fig. 13B] représentent deux procédés de génération de photons uniques selon deux modes de réalisation de l'invention,

[Fig. 14] représente un procédé de génération de paires de photons intriqués selon un mode de réalisation de l'invention,

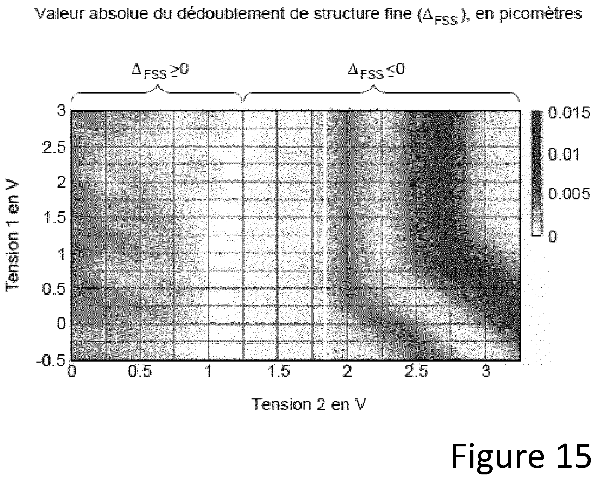

[Fig. 15] représente des mesures expérimentales du dédoublement de structure fine d'une boîte quantique anisotrope soumise à un champ électrique généré selon des modes de réalisation de l'invention.

## Description détaillée

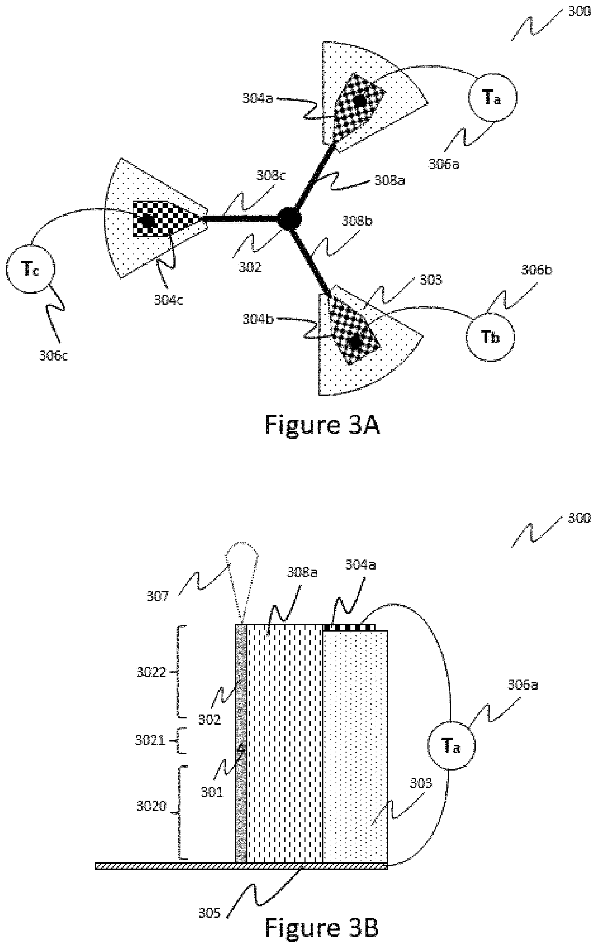

Les figures 3A et 3B représentent respectivement la vue de haut et une vue en coupe d'un dispositif de génération de photons uniques et de paires de photons intriqués 300 selon un mode de réalisation de l'invention. Le dispositif comprend une boîte quantique 301 insérée dans une cavité optique 302 de type micro-pilier. La cavité optique 302 présente une forme cylindrique et est connectée à trois piliers 303 par des bras semi-conducteurs 308a, 308b, 308c.

La boîte quantique 301 peut être de nature semi-conductrice obtenue par un procédé de croissance par jet moléculaire consistant à faire croître des couches semi-conductrices différentes en matière d'énergie de gap et de paramètres de maille. La couche formant la boîte quantique 301 peut être une couche d'Arseniure d'Indium (InAs) et les couches formant le substrat et l'encapsulant peuvent être des couches d'Arseniure de Gallium (GaAs). La boîte quantique 301 peut avoir une forme d'un cône tronqué avec une hauteur de quelques nanomètres dans l'axe de croissance et un diamètre de base d'une vingtaine de nanomètres. De telles caractéristiques confèrent à la boîte quantique 301 des propriétés proches de celles d'un atome en matière de confinement de porteurs de charge et de quantification des niveaux d'énergie.

La boîte quantique 301 peut être dans un état neutre, appelé aussi état fondamental, ou dans un état excité correspondant à la formation d'une paire électron-trou, appelé aussi exciton ou état à une excitation élémentaire. La formation d'un exciton en présence d'un porteur de charge déjà confiné dans la boîte quantique 301 correspond à un trion qui peut être quantifié de positif ou de négatif selon le signe du porteur de charge déjà confiné. Un biexciton, appelé aussi état à deux excitations élémentaires, est formé dans la boîte quantique 301 lorsque deux excitons sont simultanément confinés.

Les porteurs de charge, électrons et trous, sont des fermions caractérisés par un spin demi-entier : $\pm 1/2$ pour les électrons et $\pm 3/2$ pour les trous lourds. L'état exciton d'une boîte quantique 301 symétrique est brillant lorsque la recombinaison électron-trou s'effectue selon un processus d'émission spontanée consistant à émettre un photon. Les états excitons brillants, appelés aussi états excitons de base, correspondent à un moment angulaire total égale à $\pm 1$ et se relaxe en émettant un photon polarisé circulairement gauche ou droite selon le signe de la somme des spins.

En pratique, la boîte quantique 301 est anisotrope impliquant une levée de dégénérescence du niveau exciton de la boîte quantique 301. Les états excitons brillants dans une boîte quantique 301 anisotrope, appelés aussi états propres à une excitation élémentaire, sont des combinaisons linéaires des états excitons de base tels que définis dans une boîte quantique 301 symétrique et sont séparés d'une quantité d'énergie non nulle appelée dédoublement de structure fine.

Le micro-pilier formant la cavité optique 302 est de forme cylindrique et est composé de deux empilements de couches 3020, 3022 entourant une région centrale 3021. De telles couches sont typiquement de nature semi-conductrice et peuvent être dopées P ou N selon une configuration donnée. Par exemple, la partie supérieure de la cavité 3022 peut présenter un dopage de type P (ou N) tandis que la partie inférieure 3020 peut présenter un dopage du type opposé, de telle sorte que la cavité forme, d'un point de vue électrique, une diode PN. Chacun des deux empilements de couches 3020, 3022 forme un miroir de Bragg et est obtenu en alternant deux couches de deux matériaux différents en termes d'indice de réfraction. L'épaisseur et l'indice de réfraction de chacune des deux couches formant chacun des deux empilements 3020, 3022 peuvent être choisis de manière à ce que leur produit soit égal à $\lambda/4$, $\lambda$ étant la longueur d'onde d'opération. Le nombre de paires de couches formant l'empilement du bas 3020 en contact avec un substrat 305 peut être différent du nombre de paires de couches formant l'empilement du haut 3022. Une telle différence permet, par exemple, de privilégier une émission vers le haut des photons générés par la boîte quantique 301 pour augmenter la brillance des sources de photons 300. Chacun des deux miroirs de Bragg 3020 et 3022 permet de réfléchir une lumière incidente selon l'axe d'empilement de couches sur une large plage de longueurs d'onde centrée autour de la longueur d'onde d'opération $\lambda$. La région centrale 3021 placée entre les deux empilements 3020, 3022 peut avoir une épaisseur égale à $\lambda$ et est configurée pour contenir la boîte quantique 301. La présence de la région centrale 3021 permet de modifier la réflectivité du micro-pilier de sorte à ce que les deux miroirs de Bragg 3020, 3022 deviennent transmissives à la longueur d'onde d'opération. Le rayon du micro-pilier est de l'ordre de quelques micromètres et est choisi de sorte à permettre à au moins un mode optique, dit mode fondamental, à se propager à travers le micro-pilier avec une énergie minimale. Avantageusement, le rayon du micro-pilier peut être choisi de sorte à permettre la propagation de plusieurs modes optiques. Le micro-pilier peut avoir une symétrie de révolution impliquant deux états de polarisations dégénérés pour chacun des modes de propagation. Alternativement, le micro-pilier est un milieu biréfringent dans lequel la lumière se propage de façon anisotrope. Une telle propriété de biréfringence lève la dégénérescence de polarisation des modes de propagation optiques qui sont définis par le petit axe et le grand axe du micro-pilier, notés respectivement H et V.

Avantageusement, la cavité optique 302 présente au moins une première et une deuxième paire de modes optiques, chacune des paires de mode étant dégénérée en polarisation. Une cavité optique 302 présentant deux paires de modes dégénérées en polarisation est particulièrement utilisée dans la génération de paires de photons intriqués en faisant correspondre la longueur d'onde de relaxation du biexciton (état à deux excitations élémentaires) vers l'exciton (état à une excitation élémentaire) avec l'énergie de la première paire de modes et en faisant correspondre la longueur d'onde de relaxation de l'exciton vers l'état neutre avec l'énergie de la deuxième paire de mode, par exemple.

Les piliers 303 peuvent présenter une hauteur égale, supérieure ou inférieure à celle de la cavité optique 302. La cavité optique 302 peut être placée au centre de l'ensemble formé par les trois piliers 303 selon un espacement radial suffisant pour découpler optiquement la cavité optique 302 des piliers 303. En outre, les piliers 303 doivent être isolés électriquement entre eux, sauf au niveau de leur face inférieure, en correspondance du contact électrique 305 dont il sera question plus loin. Les piliers 303 peuvent être formés par un même empilement de couches que le micro-pilier formant la cavité optique 302. Une telle structure présente l'avantage d'être compatible avec de nombreux procédés de fabrication en salles blanches connus par l'homme du métier. Les étapes de fabrication d'une telle structure peuvent comprendre un procédé de dépôt de couches minces pour réaliser l'empilement de couches, un procédé de lithographie suivi d'un procédé de gravure sèche permettant de définir la cavité optique 302 et les trois piliers 303.

La face supérieure de chacun des piliers 303, définie comme étant la face opposée à celle en contact avec le substrat 305, comprend un plot de contact électrique 304a, 304b, 304c dont les dimensions sont choisies de sorte à ce que le plot de contact électrique 304a, 304b, 304c soit complètement porté par la face supérieure du pilier 303 correspondant. Les trois plots de contact électrique 304a, 304b, 304c peuvent présenter les mêmes propriétés électriques et la même forme géométrique qui peut être triangulaire, rectangulaire ou autre. Les dimensions transversales de tels plots de contact électrique 304a, 304b, 304c définies dans un plan perpendiculaire à l'axe d'empilement de couches (axe de croissance) sont de préférence supérieures d'au moins un facteur 10 par rapport à l'épaisseur de tels plots 304a, 304b, 304c définie selon l'axe d'empilement de couches. A titre d'exemple, l'épaisseur des plots de contact électrique 304a, 304b, 304c est choisie inférieure à 50 nanomètres et leurs dimensions transversales sont choisies supérieures à 50 micromètres ce qui permet de faciliter leur connexion aux différentes sources de tensions 306a, 306b, 306c à travers un procédé de câblage par fil, connu aussi par le terme en anglais « Wire Bonding ». Les plots de contact électrique 304a, 304b, 304c sont agencés de manière symétrique autour de la cavité optique 302 ce qui correspond à un même espacement radial entre chacun des plots de contact électrique 304a, 304b, 304c et la cavité optique 302, et à un même espacement angulaire entre chaque deux plots de contact électrique adjacents.

Les faces inférieures des piliers 303 sont connectées à un autre contact électrique 305, le contact électrique 305 étant ainsi porté par la face inférieure de la cavité optique 302. Le contact électrique 305 est réalisé sur une surface de nature semi-conductrice dont la conductivité électrique est augmentée à travers un dopage P ou N. Le contact électrique 305 peut avoir une forme d'un disque, d'un rectangle ou d'une autre forme géométrique 2D qui permet de couvrir de manière complète la face inférieure de l'ensemble formé par la cavité optique 302 et les piliers 303. Une telle configuration permet d'appliquer une différence de potentiel électrique entre chacun des plots de contact électrique 304a, 304b, 304c agencés autour de la face supérieure de la cavité optique 302 et le contact électrique 305 porté par la face inférieure de la cavité optique 302 en utilisant trois sources de tension 306a, 306b, 306c indépendantes délivrant des tensions respectives Ta, Tb et Tc. La tension délivrée par chacune des sources de tension 306a, 306b, 306c peut être constante ou variable au cours du temps.

Des bras de nature semi-conductrice 308a, 308b, 308c sont utilisés pour connecter chacun des plots de contact électrique 304a, 304b, 304c à la face supérieure de la cavité optique 302. Les matériaux formant les bras semi-conducteurs sont dopés de manière à augmenter leur conductivité électrique, sans toutefois que cette conductivité ne devienne de type métallique (dopage dégénéré). Les bras semi-conducteurs 308a, 308b, 308c peuvent avoir la même hauteur que la cavité optique 302, leur longueur est suffisamment longue pour connecter la face extérieure de la cavité optique 302 à la face intérieure des piliers 303 au-dessus desquels sont disposés les plots de contact électrique 304a, 304b, 304c, et leur largeur est suffisamment petite pour que deux bras semi-conducteurs 308a, 308b, 308c adjacents soient électriquement isolés au niveau de leur contact avec la face extérieure de la cavité optique 302. Chacun des bras semi-conducteurs 308a, 308b, 308c s'étend radialement vers le pilier 303 correspondant de sorte à ce qu'un angle de 120 degrés est formé entre chaque deux bras semi-conducteurs 308a, 308b, 308c adjacents. L'utilisation des bras diélectriques ou semi-conducteurs permet d'amplifier la composante horizontale du champ électrique appliqué en concentrant les lignes de champ.

Des photons générés par la boîte quantique 301 selon l'un des modes optiques et des photons venant exciter la boîte quantique 301 quittent et pénètrent, respectivement, la cavité optique 302 selon un même ou deux différents diagrammes de rayonnement 307 dont chacun est caractérisé par un angle d'ouverture donné.

La différence de potentiel électrique entre chacun des plots de contact électrique 304a, 304b, 304c et le contact électrique 305 porté par la face inférieure de la cavité optique 302 donne naissance à un champ électrique élémentaire et contrôle ses caractéristiques en termes d'intensité et d'orientation. Le champ électrique résultant qui règne dans la région centrale 3021 et auquel la boîte quantique 301 est soumise est la somme vectorielle de trois champs électriques élémentaires issus de la différence de potentiels électriques entre chacun des trois plots de contact électrique 304a, 304b, 304c agencés autour de la face supérieure de la cavité optique 302 et le contact électrique 305 porté par la face inférieure de la cavité optique 302. Un tel champ électrique résultant possède trois composantes : une composante verticale définie dans la même direction que l'axe de croissance (axe d'empilement de couches) de la cavité optique 302 et deux composantes horizontales définies dans le plan d'empilement de couches formant les deux miroirs de Bragg 3020, 3022. Les caractéristiques d'un tel champ électrique résultant en termes d'orientation et d'intensité sont ajustables de manière déterministe en agissant sur un ou plusieurs des champs électriques élémentaires par l'intermédiaire de la différence de potentiel électrique associée.

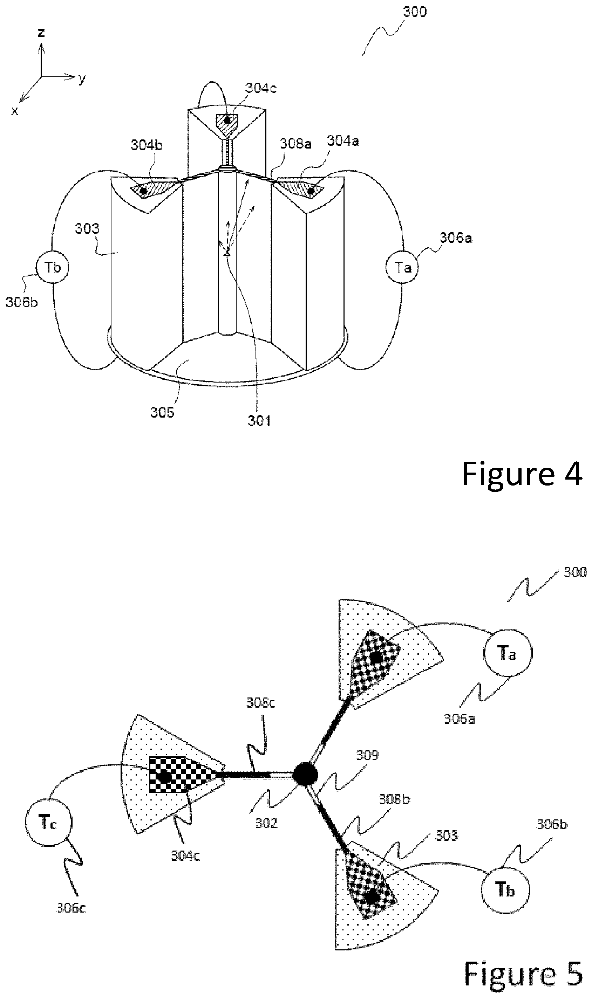

La figure 4 illustre la génération d'un champ électrique à trois composantes définies dans un trièdre orthonormé en mettant en place quatre contacts électrique selon la configuration décrite ci-dessus, deux sources de tension 306a, 306b étant représentées, les champs électriques élémentaires et le champ électrique résultant étant représentés en trait discontinu et en trait continu, respectivement. Les différentes composantes du champ électrique résultant permettent de :

- ajuster la valeur du dédoublement de structure fine de la boîte quantique 301;

- accorder la longueur d'onde d'émission associée à la relaxation de ses états excitonique brillants ; et

- définir l'orientation des axes propres de la boîte quantique 301 selon lesquels elle peut émettre ou être excitée par des photons.

Pour ajuster ces trois paramètres, il est nécessaire de disposer d'au moins trois degrés de liberté, donc d'au moins trois sources de tension indépendantes reliées à trois plots de contact électrique non colinéaires.
D'un point de vue expérimental, les paramètres intrinsèques de la boîte quantique 301, tels que le dédoublement de structure fine, ne sont pas connus avec précision à l'avance à cause des imperfections des procédés de fabrication. Les paramètres d'intérêt de la boîte quantique 301, tels le dédoublement de structure fine, les longueurs d'onde d'émission et les orientations des axes propres, sont généralement mesurés après la réalisation du dispositif de génération de photons uniques et de paires de photons intriqués 300.
La figure 5 représente une vue de haut d'une partie d'un dispositif de génération de photons uniques et de paires de photons intriqués 300 selon un autre mode de réalisation de l'invention. Dans un tel mode de réalisation, les bras semi-conducteurs 308a, 308b, 308c tels que décrits ci-dessus ne sont pas en contact direct avec la cavité optique 302. La séparation entre chaque bras semi-conducteur 308a, 308b, 308c et la cavité optique 302 est assurée par une couche de matériau diélectrique 309. La couche de matériau diélectrique 309 est configurée pour assurer l'isolation électrique entre la cavité optique 302 et les bras semi-conducteurs 308a, 308b, 308c, et son épaisseur est de l'ordre de quelques dizaines de nanomètres à quelques micromètres. Le matériau diélectrique formant la couche diélectrique 309 peut être le vide. L'isolation électrique de la cavité optique 302 de son environnement adjacent permet d'éviter qu'un courant électrique intense traverse la cavité optique 302 et perturbe le fonctionnement de la boîte quantique 301.
La figure 6 représente un autre mode de réalisation de l'invention dans lequel aucun bras semi-conducteurs n'est utilisé pour connecter la cavité optique 302 aux différents piliers 303 mis en œuvre. Dans un tel mode de réalisation, les piliers 303 sont disposés de manière symétrique autour de la cavité optique 302 et l'espacement radial entre la cavité optique 302 et chacun des piliers 303 est choisi inférieur à 10 micromètres, par exemple. Un tel espacement radial permet de soumettre la boîte quantique 301 à un champ électrique suffisamment intense pour agir sur les paramètres caractéristiques de la boîte quantique 301 incluant la valeur du dédoublement de structure fine. La séparation entre la cavité optique 302 et les piliers 303 peut être assurée par un matériau diélectrique ou par le vide.

La figure 7 représente un autre mode de réalisation de l'invention selon lequel les plots de contact électrique 304a, 304b, 304c sont portés par une structure creuse 3030 de forme cylindrique entourant la cavité optique 302. La structure creuse 3030 peut être formée par un matériau diélectrique ce qui permet l'isolation électrique entre les plots de contact électrique 304a, 304b, 304c. La structure creuse 3030 peut avoir la même hauteur que la cavité optique 302 et sa surface supérieure est choisie suffisamment large pour contenir les plots de contact électrique 304a, 304b, 304c. En outre, des bras semi-conducteurs 308a, 308b, 308c associés à une couche de matériau diélectrique 309 tels que décrits dans le mode de réalisation de la figure 5 sont utilisés pour connecter les plots de contact électrique 304a, 304b, 304c à la cavité optique 302. Alternativement, la connexion entre les plots de contact électrique 304a, 304b, 304c et la cavité optique 302 peut être assurée en rapprochant suffisamment les plots de contact électrique 304a, 304b, 304c à la cavité optique 302 tel que décrit dans la figure 6 ou en utilisant des bras semi-conducteurs 308a, 308b, 308c tel que décrit dans les figures 3A et 3B.

La figure 8 représente la structure d'une cavité optique 302 de type micro-pilier selon un mode de réalisation de l'invention. Dans un tel mode de réalisation, les deux miroirs de Bragg du haut 3022 et du bas 3020 formant le micro-pilier sont dopés P et N, respectivement. La région centrale 3021 contenant la boîte quantique 301 reste intrinsèque de sorte à ce que le micro-pilier forme, d'un point de vue électrique, une diode de type P-I-N. La concentration des impuretés utilisées pour réaliser le dopage (P ou N) peut être uniforme sur la longueur de chacun des deux miroirs de Bragg 3020, 3022. Alternativement, la concentration des impuretés peut évoluer de manière décroissante de sorte à être minimale dans les régions en contact avec la région centrale 3021. L'évolution de la concentration des impuretés peut être linéaire, logarithmique, ou autre. Avantageusement, les différentes tensions appliquées à la cavité optique 302 dopée selon l'une des configurations décrites ci-dessus correspondent à une polarisation en inverse de la jonction P-I-N formée par la cavité optique 302. Une telle polarisation en inverse garantit qu'aucun courant électrique significatif ne traverse la boîte quantique 301 et ne perturbe son émission de photons. Alternativement, la cavité optique 302 est polarisée en direct ce qui génère un courant électrique important traversant la boîte quantique 301 et qui est susceptible de perturber son fonctionnement.

Selon des modes de réalisation de l'invention, chacun des plots de contact électrique 304a, 304b, 304c entourant la face supérieure de la cavité optique 302 est connecté à l'une des bornes d'une source de tension réglable 306a, 306b, 306c. Chacune des sources de tension réglable 306a, 306b, 306c est configurée pour appliquer une différence de potentiel électrique entre le plot de contact électrique 304a, 304b, 304c auquel elle est connectée et le contact électrique 305 porté par la face inférieure de la cavité optique 302 qui est commun à toutes les sources de tension réglables 306a, 306b, 306c mises en œuvre. La tension générée par chacune des sources de tension réglables 306a, 306b, 306c mesurée entre le plot de contact électrique 304a, 304b, 304c correspondant et le contact électrique 305 peut être positive, nulle ou négative.

La figure 9 représente une vue de haut d'un dispositif de génération de photons uniques et de paires de photons intriqués 300 comprenant deux cavités optiques 302, 310 selon un autre mode de réalisation de l'invention. L'une des deux cavités optiques 302 comprend la boîte quantique 301 et peut être configurée selon l'un des modes de réalisation décrits ci-dessus. L'autre cavité optique 310 ne comprend pas de boîtes quantiques et peut avoir des paramètres opto-géométriques (taille, forme...) différents de celles de la première cavité optique 302. Les deux cavités optiques 302, 310 mises en œuvre sont configurées de sorte à être couplées optiquement selon une force de couplage donnée. L'ensemble formé par les deux cavités optiques 302, 310 présente deux paires de modes optiques dégénérés en polarisation. La première paire de modes optiques dégénérés en polarisation est configurée pour être en résonance avec les transitions entre l'état à deux excitations élémentaires (biexciton) et les deux états à une excitation élémentaire (exciton). La deuxième paire de modes optiques dégénérés en polarisation est configurée pour être en résonance avec les transitions entre les deux états à une excitation élémentaire (exciton) et l'état fondamental, appelé aussi état neutre, de la boîte quantique 301. Les modes de chacune des paires de modes optiques présentent des diagrammes de rayonnement 307 se recouvrant à 70% ou plus. Le couplage entre les deux cavités optiques 302, 310 peut aussi être configuré selon les modes de réalisation décrits dans la demande de brevet [3].

Selon des modes de réalisation de l'invention, le nombre de plots de contact électrique agencés autour de la face supérieure de la cavité optique 302 est supérieur à trois. Un tel nombre de plots de contact électrique peut être pair ou impair et peut être inférieur à 20. Les plots de contact électrique peuvent être agencés de manière non symétrique autour de la cavité optique 302 de sorte qu'au moins trois plots de contact électrique, et éventuellement leurs bras semi-conducteurs associés, ne soient pas orientés selon des directions parallèles, deux à deux. Ceci implique que l'espacement angulaire entre les plots de contact électrique adjacents et l'espacement radial, mesuré à partir de la cavité optique 302, peuvent ne pas être constants pour tous les plots de contact électrique mis en œuvre. En outre, les plots de contact électrique peuvent être placés à différentes distances du contact électrique 305, c'est-à-dire que les plots de contact électrique peuvent être placés dans des différents plans perpendiculaires à l'axe d'empilement de couches.

Selon des modes de réalisation de l'invention, le dispositif de génération de photons uniques et de paires de photons intriqués 300 peut comprendre une unité de refroidissement, par exemple à effet Peltier ou par cryogénie à azote ou hélium, configurée pour contrôler et maintenir constante la température de fonctionnement de la boîte quantique 301. Une telle température de fonctionnement peut être comprise entre 4 kelvins et 100 kelvins. De telles basses températures de fonctionnement limitent l'interaction entre la boîte quantique 301 et son environnement adjacent et permettent de maintenir la cohérence de l'état excité avec l'état fondamental sur un intervalle de temps suffisamment long pour manipuler l'état de la boîte quantique 301.

La figure 10 illustre l'évolution au cours du temps 400 des états excitoniques brillants dans une boîte quantique 301 insérée dans une cavité optique 302 de type micro-pilier, la boîte quantique 301 et la cavité optique 302 étant caractérisées par une anisotropie non nulle. L'anisotropie de la cavité optique 302 implique une levée de la dégénérescence des modes de la cavité optique 302 avec un mode de basse énergie et un mode de haute énergie en accord avec les axes propres de polarisation du micro-pilier, H et V. L'anisotropie de la boîte quantique 301 implique une levée de la dégénérescence entre les deux états excités qui deviennent séparés par une quantité d'énergie non nulle appelée dédoublement de structure fine. Chacun des deux états excités, appelées aussi états propres, de la boîte quantique 301 est associé à un état de polarisation linéaire donné, x ou y, selon lequel il peut émettre ou être excité par un photon. Généralement, les modes de la cavité optique 302, H et V, ne coïncident pas avec les directions de polarisation de la boîte quantique 301, x et y, et un angle, noté $\theta$, peut être défini pour quantifier un tel désaccord. L'excitation résonante du niveau exciton de la boîte quantique 301 par des photons polarisés linéairement selon l'un des modes de la cavité optique 302, H ou V, conduit à l'excitation des deux états propres selon une pondération qui dépend de la valeur de l'angle $\theta$. Un tel état excité résultant, 4021 ou 4020, n'est pas stable et sa phase évolue au cours du temps avec une vitesse de transfert proportionnelle à la valeur du dédoublement de structure fine. Un tel comportement peut être exploité pour ne collecter que les photons uniques générés par la boîte quantique 301 en l'excitant par des photons polarisés linéairement selon l'axe H de la cavité optique 302, par exemple, et en ne collectant que les photons générés selon un état de polarisation linéaire perpendiculaire à celui utilisé lors de l'excitation, l'axe V de la cavité optique 302, dans ce cas. Dans de telles configurations, augmenter la valeur du dédoublement de structure fine permet d'avoir des photons émis dans la direction de polarisation de détection avant qu'ils ne soient spontanément émis dans la direction de polarisation d'excitation. Dans un second temps, il convient de diminuer la valeur du dédoublement de structure fine afin limiter la probabilité d'avoir deux photons émis au lieu d'un au sein d'une même période d'excitation.

La figure 11 représente un dispositif de génération de photons uniques 300 selon un mode de réalisation de l'invention. Un tel mode de réalisation met en œuvre une boîte quantique 301 anisotrope incorporée dans une cavité optique 302 biréfringente de type micro-pilier. La boîte quantique 301 est soumise à un champ électrique ajustable en intensité et en orientation à travers des plots de contact électrique 304a, 304b, 304c, 305 agencés selon l'un des modes de réalisation décrits ci-dessus, le plot 304c et la source de tension 306c associée étant cachés dans la figure 11. Le dispositif de génération de photons uniques 300 comprend une source laser excitatrice 501 configurée pour générer des impulsions lumineuses destinées à pomper optiquement la boîte quantique 301 de sorte à transformer son état d'un état neutre à un état excité. L'état de polarisation des impulsions lumineuses est linéaire selon l'un des axes propres de la cavité optique 302 et la longueur d'onde associée est choisie de sorte que l'énergie transportée par les photons soit suffisamment grande pour exciter la boîte quantique 301. La durée des impulsions lumineuses et leur fréquence de répétition détermine la cadence en nombre de photons par seconde générés par le dispositif de génération de photons uniques 300. Le dispositif de génération de photons uniques 300 comprend en outre un cube séparateur de polarisation 502 et une lentille convergente 503 configurés respectivement pour isoler les photons générés dans la cavité optique 302 selon un état de polarisation linéaire selon une direction perpendiculaire à celle des photons d'excitation et pour améliorer le couplage optique entre le cube séparateur de polarisation 502 et la cavité optique 302. Les axes propres de la cavité optique 302, H et V, sont configurés pour ne pas être colinéaires avec les axes propres de la boîte quantique 301, x et y, selon un angle $\theta$, idéalement égal à 45 degrés.

La figure 12 représente un procédé d'étalonnage 600 d'une boîte quantique 301 anisotrope soumise à un champ électrique tel qu'illustré dans la figure 4. Les trois composantes dans l'espace du champ électrique résultant sont indépendamment ajustables au moyen d'au moins trois sources de tension réglables. Le procédé est itératif et consiste, à chaque itération, à modifier l'intensité d'au moins une des trois composantes du champ électrique résultant (étape 601) et à mesurer, en deuxième temps, le ou les paramètres caractéristiques d'intérêt de la boîte quantique 301 associés au champ électrique résultant appliqué (étape 602). Le procédé peut être arrêté lorsque les valeurs voulues des paramètres caractéristiques d'intérêt sont obtenues et peut retourner les valeurs des tensions appliquées aux différents plots de contact électrique. La première itération du procédé peut correspondre à un champ électrique résultant d'intensité nulle.

Le procédé d'étalonnage peut être utilisé pour identifier le point de fonctionnement d'un dispositif de génération de paires de photons intriqués 300. Les paramètres caractéristiques d'intérêt pour un tel dispositif comprennent le dédoublement de structure fine qui doit être significativement réduit, idéalement mis à zéro, et les longueurs d'onde d'émission correspondant à la relaxation du biexciton et à la relaxation de l'exciton.

Le procédé d'étalonnage peut en outre être utilisé pour trouver un point de fonctionnement optimal d'un dispositif de génération de photons uniques 300 opérant dans un mode statique selon lequel le dédoublement de structure fine caractérisant la boîte quantique 301 anisotrope mise en œuvre est ajusté de manière statique avant la création de quelconque exciton. Le dédoublement de structure fine doit permettre une vitesse de transfert suffisante pour que l'état excité puisse se relaxer selon un état de polarisation linéaire perpendiculaire à celui des photons excitants au bout d'un temps de transfert inférieur à la durée de l'impulsion optique d'excitation. Le dédoublement de structure fine peut en outre être optimisée de sorte à :

- ce qu'il soit supérieur à une limite inférieure à partir de laquelle l'état excité peut se relaxer, selon un état de polarisation linéaire perpendiculaire à celui des photons excitants, au bout d'un temps de transfert inférieur au moins d'un facteur de 3 et de préférence d'au moins un facteur 5 par rapport à la durée de vie par émission spontanée de l'état excitonique ;

- ce qu'il soit inférieur à une limite supérieure à partir de laquelle la boîte quantique 301 peut émettre plus qu'un photon pendant la durée de l'impulsion optique d'excitation.

La figure 13A est un organigramme d'un procédé de génération de photons uniques 700a au moyen du dispositif de génération de photons 300 selon un mode de réalisation de l'invention. Dans un tel mode de réalisation, le dédoublement de structure fine caractérisant la boîte quantique 301 anisotrope mise en œuvre est ajusté de manière statique. La première étape du procédé 701a consiste à appliquer entre chacun des plots de contact électrique 304a, 304b, 304c et le contact électrique 305 porté par la face inférieure de la cavité optique 302 une différence de potentiel électrique de sorte à générer un champ électrique résultant auquel la boîte quantique 301 est soumise. Les composantes d'un tel champ électrique résultant sont ajustées de sorte à optimiser la valeur du dédoublement de structure fine tel que décrit ci-dessus. En plus d'accorder la longueur d'onde des photons uniques générés par la boîte quantique 301, l'application du champ électrique résultant dans les trois directions de l'espace permet de définir les orientations des axes propres de la boîte quantique 301 de sorte à ne pas être colinéaires avec les axes propres de la cavité optique 302 dans laquelle la boîte quantique 301 est insérée. Avantageusement, les axes propres de la boîte quantique 301 sont orientés à 45 degrés par rapport aux axes propres de la cavité optique 302.

La deuxième étape du procédé 702a consiste à éclairer la boîte quantique 301 par un train d'impulsions lumineuses dont le spectre de longueurs d'onde et l'état de polarisation correspondent à l'un des modes de la cavité optique 302 dans laquelle la boîte quantique 301 est insérée. La durée des impulsions lumineuses est choisie de sorte à être suffisamment longue pour exciter la boîte quantique 301 et pourvoir émettre au moins un photon selon le processus d'émission spontanée.

La figure 13B est un organigramme d'un procédé de génération de photons uniques 700b au moyen du dispositif de génération de photons 300 selon un autre mode de réalisation de l'invention. Dans un tel mode de réalisation, le dédoublement de structure fine caractérisant la boîte quantique anisotrope 301 est contrôlé de manière dynamique. Un tel contrôle dynamique s'effectue à travers une modulation du champ électrique résultant auquel la boîte quantique 301 est soumise de sorte à pouvoir modifier la valeur du dédoublement de structure fine dans un intervalle de temps inférieur au temps d'émission spontanée caractérisant la boîte quantique 301.

La première étape du procédé 701b consiste à éclairer la boîte quantique par un train d'impulsions lumineuses dont le spectre de longueurs d'onde et l'état de polarisation correspondent à un mode de la cavité optique 302 incorporant la boîte quantique 301. La durée des impulsions lumineuses est choisie de sorte à être suffisamment longue pour exciter la boîte quantique et pourvoir émettre au moins un photon selon le processus d'émission spontanée.

La deuxième étape du procédé 702b consiste à appliquer une différence de potentiel électrique entre chacun des plots de contact électrique 304a, 304b, 304c et le contact électrique 305 porté par la face inférieure de la cavité optique 302 de sorte à générer un champ électrique résultant auquel la boîte quantique 301 est soumise. La valeur du dédoublement de structure fine augmente en fonction de l'intensité du champ électrique résultant qui doit rester inférieure à un seuil correspondant à l'endommagement de la boîte quantique 301, c'est-à-dire un seuil à partir duquel les caractéristiques électriques et optiques telles que déterminées lors du l'étalonnage de la boîte quantique 301 ne peuvent plus se rétablir. L'intensité du champ électrique résultant est choisie assez élevée pour que l'évolution temporelle de la phase de l'état excité créée soit comprise entre 45 degrés et 135 degrés, et de préférence entre 80 degrés et 100 degrés. Une telle évolution temporelle de la phase doit en outre se produire dans un temps inférieur (au moins d'un facteur 3 et de préférence d'au moins un facteur 5) de la durée de vie par émission spontanée de l'état excitonique.

La troisième étape du procédé 703b peut être déclenchée immédiatement après que l'évolution temporelle de la phase de l'état excitonique initial telle que requise est achevée. Une telle étape du procédé consiste à modifier l'intensité du champ électrique résultant de sorte à minimiser l'écart en énergie entre les deux états propres à une excitation élémentaire.

La figure 14 représente un procédé de génération de paires de photons intriqués 800 au moyen du dispositif de génération de photons 300 selon un mode de réalisation de l'invention. Un tel dispositif de génération de photons 300 met en œuvre une boîte quantique anisotrope 301 incorporée dans une cavité optique 302 présentant au moins une première et une deuxième paire de modes optiques, chacun des paires de modes optiques étant dégénéré en polarisation. L'intrication des photons générés est obtenue grâce à un contrôle statique du dédoublement de structure fine caractérisant la boîte quantique anisotrope 301 mise en œuvre. La première étape du procédé 801 consiste à appliquer une différence de potentiel électrique en chacun des plots de contact électrique 304a, 304b, 304c et le contact électrique 305 porté par la face inférieure de la cavité optique 302. De telles différences de potentiel électrique sont optimisées de sorte à réduire l'écart en énergie entre les deux états à une excitation élémentaire défini par le dédoublement de structure fine de la boîte quantique 301. En particulier, l'étape 801 peut consister à annuler le dédoublement de structure fine ce qui rend la boîte quantique 301 un système à trois niveaux d'énergie relativement à la relaxation d'un biexciton. Les différences de potentiel électrique sont en outre réglées de sorte à ce que :

- la transition entre l'état à deux excitations élémentaires et les états à une excitation élémentaire soit en résonnance avec la première paire de modes de la cavité optique 302 ; et

- la transition entre les états à une excitation élémentaire et l'état fondamental soit en résonance avec la deuxième paire de modes de la cavité optique 302.

La deuxième étape du procédé 802 consiste à peupler l'état à deux excitations élémentaires de la boîte quantique 301 par un apport d'énergie. La création d'un tel état biexcitonique XX peut être réalisée en excitant la boîte quantique 301 par deux photons successifs d'énergies adéquates : Un premier photon d'énergie $\omega_X$ suffisante pour exciter la transition d'un premier exciton et un deuxième photon d'énergie $\omega_{XX}$ différente de $\omega_X$ pour créer un deuxième exciton et obtenir ainsi un état biexcitonique XX, ou alternativement deux photons d'énergie $(\omega_{XX} + \omega_X)/2$.

La figure 15 illustre des mesures expérimentales du dédoublement de structure fine caractérisant une boîte quantique 301 anisotrope incorporée dans une cavité optique 302 de type micro-pilier, la face supérieure de la cavité optique 302 étant entourée par deux plots de contact électrique 304a, 304b selon des modes de réalisation de l'invention. Les mesures expérimentales sont effectuées pour deux plages de tension appliquées aux plots de contact électrique 304a, 304b et illustrent les avantages techniques des modes de réalisation de l'invention en termes de contrôle déterministe de la valeur du dédoublement de structure fine. De telles mesures sont obtenues pour la configuration suivante : la boîte quantique 301 est excitée par un laser d'énergie supérieure à la transition optique correspondant à l'exciton. Cette excitation non résonante permet de peupler les deux états excitoniques 2020 et 2021 qui émettent alors des photons à deux longueurs d'onde différentes qui sont collectés. La différence de longueurs d'onde entre les deux photons permet d'extraire la valeur du dédoublement de structure fine. La figure 15 montre le résultat d'une telle mesure où l'échelle de couleur reflète la valeur absolue du dédoublement de structure fine, en fonction de deux tensions appliquées sur les contacts 304a et 304b. La figure montre que le dédoublement de structure fine change en valeur absolue en fonction des tensions appliquées et change de signe en s'annulant pour toute une gamme de couples de tension 1 et tension 2.

Selon un mode de réalisation de l'invention, la formation d'un exciton dans une boîte quantique 301 initialement neutre s'effectue par un pompage optique non résonant consistant à exciter la boîte quantique 301 par un photon d'énergie supérieure à la bande interdite du matériau formant la boîte quantique 301.

Selon un autre mode de réalisation de l'invention, la forme géométrique du micro-pilier formant la cavité optique 302 définie dans le plan perpendiculaire à l'axe de croissance peut être elliptique, polygonale ou autre.

L'invention n'est pas limitée aux modes de réalisation décrits ci-avant à titre d'exemple non limitatif. Elle englobe toutes les variantes de réalisation qui pourront être envisagées par l'homme du métier.

[REFERENCES]

[1] Trotta, Rinaldo et al. "Highly Entangled Photons from Hybrid Piezoelectric-Semiconductor Quantum Dot Devices." Nano Letters 14.6 (2014): 3439-3444.

[2] K Kowalik, O Krebs, A Lemaitre, S Laurent, P Senellart, P Voisin, JA Gaj "Influence of an in-plane electric field on exciton fine structure inInAs-GaAs self-assembled quantum dots." Applied Physics Letters 86 (4), 041907|

[3] WO/2011/089336 « SOURCE DE PAIRES DE PHOTONS INTRIQUES EN POLARISATION ET SON PROCEDE DE FABRICATION"

[4] N. SOMASCHI ET AL: "Near-optimal single-photon sources in the solid state",NATURE PHOTONICS, vol. 10, no. 5, 7 mars 2016 (2016-03-07), pages 340-345

**Revendications**

1.  Dispositif de génération de photons (300) comprenant une boîte quantique (301) insérée dans une cavité optique (302) de type micro-pilier présentant au moins un mode optique, la boîte quantique (301) présentant au moins un état fondamental et deux états à une excitation élémentaire, la cavité optique (302) présentant une face inférieure et une face supérieure, la face inférieure portant un contact électrique (305), ledit dispositif comprenant au moins trois plots de contact électrique (304a, 304b, 304c) isolés électriquement les uns des autres, agencés autour de la face supérieure de la cavité (302), **caractérisé en ce que** ledit dispositif comprend également au moins trois sources de tension réglables (306a, 306b, 306c) pour appliquer des différences de potentiel respectives et variables entre chacun desdits plots de contact électrique (304a, 304b, 304c) et le contact électrique (305) porté par la face inférieure de la cavité optique (302).

2.  Dispositif (300) selon la revendication 1 dans lequel les plots de contact électrique (304a, 304b, 304c) sont reliés à la face supérieure de la cavité (302) par des bras semi-conducteurs (308a, 308b, 308c) orientés radialement par rapport à la cavité (302) et présentant, dans une direction tangentielle et, à leur extrémité la plus proche, de la cavité, une largeur inférieure à celle de la cavité (302).

3.  Dispositif (300) selon la revendication 1 dans lequel les plots de contact électrique (304a, 304b, 304c) sont reliés à des bras semi-conducteurs orientés radialement vers la cavité (302) et dont les extrémités sont séparés de la face supérieure de la cavité (302) par un intervalle vide (309), ou rempli de diélectrique, de largeur sub-micrométrique.

4.  Dispositif (300) selon l'une quelconque des revendications précédentes dans lequel la cavité optique (302) de type micro-pilier forme une diode de type P-I-N, la boîte quantique (301) étant située dans une région intrinsèque (3021) de ladite diode.

5.  Dispositif (300) selon l'une quelconque des revendications précédentes dans lequel les plots de contact électrique (304a, 304b, 304c) sont portés par des piliers respectifs (303) découplés optiquement et électriquement de la cavité (302).

6.  Dispositif (300) selon l'une quelconque des revendications précédentes dans lequel ladite cavité optique (302) de type micro-pilier présente au moins une première et une deuxième paire de modes, chaque dite paire de modes étant dégénérée en polarisation, et dans lequel ladite boîte quantique (301) présente également un état à deux excitations élémentaires.

7.  Dispositif (300) selon la revendication 6, comprenant également une deuxième cavité optique (310) couplée à la cavité optique (302) dans laquelle est insérée la boîte quantique (301), la géométrie de la première et de la deuxième cavité (302, 310) et la force de leur couplage étant choisies de telle manière que l'ensemble constitué par les deux cavités couplées présente une première paire de modes dégénérés en polarisation et résonants avec les transitions entre l'état à deux excitations élémentaires et les deux états à une excitation élémentaire de la boîte quantique (301) et une deuxième paire de modes dégénérés en polarisation et résonants avec les transitions entre les deux états à une excitation élémentaire et l'état fondamental de la boîte quantique (301), les modes de chacune desdites paires présentant des diagrammes de rayonnement se recouvrant à 70% ou plus.

8.  Dispositif (300) selon la revendication 7 dans lequel la deuxième cavité optique (310) est également de type micro-pilier, les deux cavités (302, 310) étant agencées côte à côte.

9.  Procédé (800) de génération de paires de photons intriqués au moyen d'un dispositif (300) selon l'une des revendications 6 à 8, le procédé comprenant les étapes suivantes :

    - appliquer une différence de potentiel entre chacun desdits plots de contact électrique (304a, 304b, 304c) et le contact électrique (305) porté par la face inférieure de la cavité optique (302), lesdites différences de potentiel étant choisies pour :

      ○ minimiser un écart d'énergie entre les deux états à une excitation de la boîte quantique (301); et
      ○ amener les transitions entre l'état à deux excitations élémentaires et les états à une excitation élémentaire en résonance avec la première paire de modes de la cavité (302), et les transitions entre les états à une excitation élémentaire et l'état fondamental en résonance avec la deuxième paire de modes de la cavité (302); et

    - peupler l'état à deux excitations élémentaires de la boîte quantique (301) par un apport d'énergie.

10. Procédé de génération de photons uniques (700a) au moyen d'un dispositif (300) selon l'une des revendications 1 à 6 comprenant les étapes suivantes :

- appliquer une différence de potentiel entre chacun desdits plots de contact électrique (304a, 304b, 304c) et le contact électrique (305) porté par la face inférieure de la cavité optique (302) ; et
- éclairer la boîte quantique (301) du dispositif par une impulsion lumineuse présentant un spectre et une direction de polarisation correspondant à un mode de la cavité optique (302) ;

lesdites différences de potentiel étant choisies pour modifier les énergies des deux états propres à une excitation élémentaires de telle sorte que :

∘ lesdits états soient résonant avec des longueurs d'onde du spectre de l'impulsion lumineuse ; et
∘ la probabilité d'émission, par la boîte quantique (301), d'un photon unique présentant une polarisation linéaire orthogonale à celle d'éclairage soit maximisée.

11. Procédé selon la revendication 10 dans lequel lesdites différences de potentiel sont également choisies pour orienter des axes propres de la boîte quantique (301) selon des directions intermédiaires entre celles de deux axes propres de polarisation de la cavité optique (302).

12. Procédé (700b) selon l'une des revendications 10 et 11 dans lequel lesdites différences de potentiel sont variables dans le temps et :

- pendant une première période, au cours d'au moins une partie de laquelle la boîte quantique (301) est éclairée, prennent des premières valeurs choisies pour que les énergies des deux états propres à une excitation élémentaires présentent un écart non minimal, la première période présentant une durée choisie pour provoquer un évolution de phase comprise entre 45° et 135°, et de préférence entre 80° et 100°, entre les deux dits états ; et
- pendant une deuxième période, succédant immédiatement à la première période, prennent des valeurs choisies pour minimiser l'écart entre les énergies des deux états propres à une excitation élémentaire.

**Patentansprüche**

1. Vorrichtung (300) zum Erzeugen von Photonen, die einen Quantenpunkt (301) umfasst, der in einen optischen Resonator (302), bei dem es sich um einen Mikrosäulenresonator handelt, mit mindestens einem optischen Modus eingesetzt ist, wobei der Quantenpunkt (301) mindestens einen Grundzustand und bei einer elementaren Anregung zwei Zustände aufweist, wobei der optische Resonator (302) eine Unterseite und eine Oberseite aufweist, wobei die Unterseite einen elektrischen Kontakt (305) trägt, wobei die Vorrichtung mindestens drei elektrische Kontaktflächen (304a, 304b, 304c) umfasst, die elektrisch voneinander isoliert und um die Oberseite des Resonators (302) angeordnet sind, **dadurch gekennzeichnet, dass** die Vorrichtung außerdem mindestens drei einstellbare Spannungsquellen (306a, 306b, 306c) zum Anlegen jeweiliger variabler Potenzialdifferenzen zwischen den einzelnen elektrischen Kontaktflächen (304a, 304b, 304c) und dem elektrischen Kontakt (305), der von der Unterseite des optischen Resonators (302) getragen wird, umfasst.

2. Vorrichtung (300) nach Anspruch 1, wobei die elektrischen Kontaktflächen (304a, 304b, 304c) mit der Oberseite des Resonators (302) durch Halbleiterarme (308a, 308b, 308c) verbunden sind, die radial zum Resonator (302) orientiert sind und in tangentialer Richtung und an ihrem dem Resonator nächstgelegenen Ende eine geringere Breite als der Resonator (302) aufweisen.

3. Vorrichtung (300) nach Anspruch 1, wobei die elektrischen Kontaktflächen (304a, 304b, 304c) mit Halbleiterarmen verbunden sind, die radial zum Resonator (302) orientiert sind und deren Enden von der Oberseite des Resonators (302) durch einen leeren (309) oder mit Dielektrikum gefüllten Zwischenraum mit einer Breite im Submikrometerbereich getrennt sind.

4. Vorrichtung (300) nach einem der vorhergehenden Ansprüche, wobei der optische Mikrosäulenresonator (302) eine P-I-N-Diode bildet, wobei sich der Quantenpunkt (301) in einer intrinsischen Region (3021) der Diode befindet.

5. Vorrichtung (300) nach einem der vorhergehenden Ansprüche, wobei die elektrischen Kontaktflächen (304a, 304b, 304c) von jeweiligen Säulen (303) getragen werden, die optisch und elektrisch vom Resonator (302) entkoppelt sind.

6. Vorrichtung (300) nach einem der vorhergehenden Ansprüche, wobei der optische Mikrosäulenresonator (302) mindestens ein erstes und ein zweites Paar Modi aufweist, wobei jedes dieser Modi-Paare polarisationsentartet ist, und wobei der Quantenpunkt (301) auch einen Zustand mit zwei elementaren Anregungen aufweist.

7. Vorrichtung (300) nach Anspruch 6, die ferner einen zweiten optischen Resonator (310) umfasst, der mit dem optischen Resonator (302) gekoppelt ist, in den der Quantenpunkt (301) eingesetzt ist, wobei die Geometrie des ersten und des zweiten Resonators (302, 310) und die Stärke ihrer Kopplung so gewählt sind, dass die aus den beiden gekoppelten Resonatoren bestehende Anordnung ein erstes Paar von hinsichtlich Polarisation und Resonanz entarteten Modi, die mit den Übergängen zwischen dem Zustand mit zwei elementare Anregungen und den beiden Zuständen mit einer elementare Anregung des Quantenpunkts (301) in Resonanz sind, sowie ein zweites Paar von hinsichtlich Polarisation und Resonanz entarteten Modi, die mit den Übergängen zwischen den beiden Zuständen mit einer elementare Anregung und dem Grundzustand des Quantenpunkts (301) in Resonanz sind, aufweist, wobei die Modi jedes dieser Paare Strahlungsmuster aufweisen, die sich zu 70 % oder mehr überlappen.

8. Vorrichtung (300) nach Anspruch 7, wobei es sich bei dem zweiten optischen Resonator (310) um einen Mikrosäulenresonator handelt und die beiden Resonatoren (302, 310) nebeneinander angeordnet sind.

9. Verfahren (800) zum Erzeugen von verschränkten Photonenpaaren mittels einer Vorrichtung (300) nach einem der Ansprüche 6 bis 8, wobei das Verfahren die folgenden Schritte umfasst:

   - Anlegen einer Potenzialdifferenz zwischen jeder der elektrischen Kontaktflächen (304a, 304b, 304c) und dem elektrischen Kontakt (305), der von der Unterseite des optischen Resonators (302) getragen wird, wobei die Potenzialdifferenzen gewählt werden zum:

      ◦ Minimieren eines energetischen Abstands zwischen den beiden Zuständen mit einer Anregung des Quantenpunkts (301); und
      ◦ In-Resonanz-Bringen der Übergänge zwischen dem Zustand mit zwei elementaren Anregungen und den Zuständen mit einer elementare Anregung mit dem ersten Paar Modi des Resonators (302) und In-Resonanz-Bringen der Übergänge zwischen den Zuständen mit einer elementare Anregung und dem Grundzustand mit dem zweiten Paar Modi des Resonators (302); und

   - Füllen des Zustands mit zwei elementare Anregungen des Quantenpunkts (301) mit einem Energieeintrag.

10. Verfahren zum Erzeugen einzelner Photonen (700a) mittels einer Vorrichtung (300) nach einem der Ansprüche 1 bis 6, umfassend die folgenden Schritte:

   - Anlegen einer Potenzialdifferenz zwischen jeder der elektrischen Kontaktflächen (304a, 304b, 304c) und dem elektrischen Kontakt (305), der von der Unterseite des optischen Resonators (302) getragen wird; und
   - Beleuchten des Quantenpunkts (301) der Vorrichtung mit einem Lichtimpuls, dessen Spektrum und Polarisationsrichtung einem Modus des optischen Resonators (302) entsprechen;

   wobei die Potenzialdifferenzen so gewählt werden, dass die Energien der beiden für eine elementare Anregung spezifischen Zustände so verändert werden, dass:

      ◦ die Zustände mit Wellenlängen des Spektrums des Lichtimpulses in Resonanz sind; und
      ◦ die Wahrscheinlichkeit der Emission eines einzelnen Photons mit einer zu der der Beleuchtung orthogonalen linearen Polarisation durch den Quantenpunkt (301) maximiert wird.

11. Verfahren nach Anspruch 10, wobei die Potenzialdifferenzen ferner so gewählt werden, dass die dem Quantenpunkt (301) zugehörigen Achsen in Richtungen ausgerichtet sind, die zwischen den beiden der Polarisation des optischen Resonators (302) zugehörigen Achsen liegen.

12. Verfahren (700b) nach einem der Ansprüche 10 und 11, wobei die Potenzialdifferenzen zeitlich variabel sind und:

   - während eines ersten Zeitraums, während dessen der Quantenpunkt (301) zumindest teilweise beleuchtet ist, erste Werte annehmen, die so gewählt sind, dass die Energien der beiden für eine elementare Anregung spezifischen Zustände einen nicht-minimalen Abstand aufweisen, wobei der erste Zeitraum eine Dauer aufweist, die so gewählt ist, dass eine Phasenentwicklung zwischen 45° und 135°, vorzugsweise zwischen 80° und 100°, zwischen diesen beiden Zuständen auftritt; und
   - während eines zweiten Zeitraums, der unmittelbar auf dem Zeitraum folgt, Werte annehmen, die so gewählt sind, dass der Abstand zwischen den Energien der beiden für eine elementare Anregung spezifischen Zustände minimiert wird.

## Claims

1. A device for generating photons (300) comprising a quantum box (301) inserted into an optical cavity (302) of micro-pillar type having at least one optical mode, the quantum box (301) having at least one fundamental state and two states with one elementary excitation, the optical cavity (302) having a bottom face and a top face, the bottom face bearing an electrical contact (305), said device comprising at least three electrical bonding pads (304a, 304b, 304c) that are electrically insulated from one another, arranged around the top face of the cavity (302), **characterized in that** said device comprises also at least three adjustable voltage sources (306a, 306b, 306c) for applying respective and variable potential differences between each of said electrical bonding pads (304a, 304b, 304c) and the electrical contact (305) borne by the bottom face of the optical cavity (302).

2. The device (300) as claimed in claim 1, wherein the electrical bonding pads (304a, 304b, 304c) are linked to the top face of the cavity (302) by semiconductor arms (308a, 308b, 308c) that are oriented radially with respect to the cavity (302) and that have, in a tangential direction and, at their end closest to the cavity, a width less than that of the cavity (302).

3. The device (300) as claimed in claim 1, wherein the electrical bonding pads (304a, 304b, 304c) are linked to semiconductor arms oriented radially toward the cavity (302) and of which the ends are separated from the top face of the cavity (302) by an empty gap (309), or one that is filled with dielectric of sub-micrometric width.

4. The device (300) as claimed in any one of the preceding claims, wherein the optical cavity (302) of micro-pillar type forms a diode of P-I-N type, the quantum box (301) being situated in an intrinsic region (3021) of said diode.

5. The device (300) as claimed in any one of the preceding claims, wherein the electrical bonding pads (304a, 304b, 304c) are borne by respective pillars (303) decoupled optically and electrically from the cavity (302).

6. The device (300) as claimed in any one of the preceding claims, wherein said optical cavity (302) of micro-pillar type has at least one first and one second pair of modes, each said pair of modes being polarization degenerate, and wherein said quantum box (301) has also one state with two elementary excitations.

7. The device (300) as claimed in claim 6, also comprising a second optical cavity (310) coupled to the optical cavity (302) into which the quantum box (301) is inserted, the geometry of the first cavity and of the second cavity (302, 310) and the force of their coupling being chosen such that the assembly composed of the two coupled cavities has a first pair of modes that are polarization degenerate and resonant with transitions between the state with two elementary excitations and the two states with one elementary excitation of the quantum box (301) and a second pair of modes that are polarization degenerate and resonant with the transitions between the two states with one elementary excitation and the fundamental state of the quantum box (301), the modes of each of said pairs having radiation patterns that overlap by 70% or more.

8. The device (300) as claimed in claim 7, wherein the second optical cavity (310) is also of micro-pillar type, the two cavities (302, 310) being arranged side-by-side.

9. A method (800) for generating entangled photon pairs by means of a device (300) as claimed in one of claims 6 to 8, the method comprising the following steps:

   - applying a potential difference between each of said electrical bonding pads (304a, 304b, 304c) and the electrical contact (305) borne by the bottom face of the optical cavity (302), said potential differences being chosen to:

     ◦ minimize an energy difference between the two states with one excitation of the quantum box (301); and
     ◦ bring the transitions between the state with two elementary excitations and the states with one elementary excitation into resonance with the first pair of modes of the cavity (302), and the transitions between the states with one elementary excitation and the fundamental state into resonance with the second pair of modes of the cavity (302), and

   - populate the state with two elementary excitations of the quantum box (301) with an input of energy.

10. The method for generating single photons (700a) by means of a device (300) as claimed in one of claims 1 to 6 comprising the following steps:

    - applying a potential difference between each of said electrical bonding pads (304a, 304b, 304c) and the electrical contact (305) borne by the bottom face of the optical cavity (302); and

- lighting the quantum box (301) of the device by a light pulse exhibiting a spectrum and a direction of polarization corresponding to a mode of the optical cavity (302);

said potential differences being chosen to modify the energies of the two eigenstates with one elementary excitation in such a way that:

    ◦ said states are resonant with wavelengths of the spectrum of the light pulse; and
    ◦ the probability of emission, by the quantum box (301), of a single photon exhibiting a linear polarization orthogonal to that of the lighting is maximized.

11. The method as claimed in claim 10, wherein said potential differences are also chosen to orient specific axes of the quantum box (301) according to intermediate directions between those of two specific axes of polarization of the optical cavity (302).

12. The method (700b) as claimed in one of claims 10 and 11, wherein said potential differences are variable in time, and:

    - during a first period, during at least a part of which the quantum box (301) is lit, take first values chosen for the energies of the two eigenstates with one elementary excitation to exhibit a non-minimal deviation, the first period having a duration chosen to provoke a change of phase of between 45° and 135°, and preferably to between 80° and 100°, between the two said states; and

during a second period, immediately succeeding the first period, take values chosen to minimize the deviation between the energies of the two eigenstates with one elementary excitation.

Figure 1

Figure 2

Figure 3A

Figure 3B

Figure 4

Figure 5

Figure 6

Figure 7

Figure 8

Figure 9

Figure 10

Figure 11

700b

701b

Éclairer la boîte
quantique

702b

Augmenter la valeur du
dédoublement de
structure fine

703b

Réduire la valeur du
dédoublement de
structure fine

## Figure 13B

800

801

Réduire la valeur du
dédoublement de
structure fine

802

Peupler l'état à deux
excitations élémentaires

## Figure 14

Valeur absolue du dédoublement de structure fine ($\Delta_{FSS}$), en picomètres

Figure 15

## RÉFÉRENCES CITÉES DANS LA DESCRIPTION

**Documents brevets cités dans la description**

- WO 2011089336 A

**Littérature non-brevet citée dans la description**

- **TROTTA, RINALDO et al.** Highly Entangled Photons from Hybrid Piezoelectric-Semiconductor Quantum Dot Devices. *Nano Letters*, 2014, vol. 14 (6), 3439-3444

- **K KOWALIK** ; **O KREBS** ; **A LEMAITRE** ; **S LAURENT** ; **P SENELLART** ; **P VOISIN** ; **JA GAJ**. Influence of an in-plane electric field on exciton fine structure inInAs-GaAs self-assembled quantum dots.. *Applied Physics Letters*, vol. 86 (4), 041907

- **N. SOMASCHI et al.** Near-optimal single-photon sources in the solid state. *NATURE PHOTONICS*, 07 March 2016, vol. 10 (5), 340-345